# EUROPEAN PATENT APPLICATION

(11) **EP 4 682 561 A1**
(43) Date of publication of application: **21.01.2026**
(21) Application number: 23927524.1
(22) Date of filing: 16.03.2023
(51) Int. Cl.: G01R 31/392, G01R 31/367, G01R 31/389

(54) **STORAGE CELL DIAGNOSTIC DEVICE, DIAGNOSTICS SYSTEM, AND DIAGNOSTIC METHOD**

(71) Applicant: Kabushiki Kaisha Toshiba, Tokyo 105-0023 (JP)
(72) Inventor: UEMURA, Yohei, Tokyo 105-0023 (JP)
(74) Representative: Hoffmann Eitle
(86) International application number: PCT/JP2023/010348
(87) International publication number: WO 2024/189905

(57) **Abstract**

In an embodiment, a diagnosis apparatus includes a processing circuit, and the processing circuit measures temporal changes in current and voltage of a storage battery where a pseudo-random pulse signal of current is input to the storage battery. By using a machine learning model which outputs an internal state of the storage battery in response to input of electrical characteristic data based on current time series data and voltage time series data of the storage battery, the processing circuit inputs target electrical characteristic data based on a measurement result regarding the temporal changes in the current and the voltage as the electrical characteristic data to the machine learning model, and estimates the internal state of the storage battery based on a result of outputting from the machine learning model in response to the input of the target electrical characteristic data.

## Description

### FIELD

Embodiments of the present invention relate to a diagnosis apparatus, a diagnosis system, and a diagnosis method of a storage battery.

### BACKGROUND

In diagnosis, etc., of a deterioration state of a storage battery, the frequency characteristics of an impedance of such a storage battery are measured and based on the measurement results of the frequency characteristics of the impedance, a resistance component or full charge capacity, etc., of the storage battery is estimated. In measurement of the frequency characteristics of an impedance of a storage battery, for example, a current waveform whose current value varies periodically is input to the storage battery at each of the plurality of frequencies, and temporal changes in current and voltage of the storage battery are measured in a state in which the current waveform is input to the storage battery. The measurement results of the temporal changes in current and voltage of the storage battery are then subjected to Fourier analysis to measure the impedance of the storage battery at each of the plurality of frequencies, thereby measuring the frequency characteristics of the impedance of the storage battery.

Furthermore, in estimation of a resistance component of a storage battery based on measurement results of impedance frequency characteristics of the storage battery, for example, a fitting calculation is performed using the measurement results of the impedance frequency characteristics and an equivalent circuit model of the storage battery. At this time, a fitting calculation is performed using, as variables, circuit parameters set in the equivalent circuit model including a resistance component of a storage battery, and the resistance component of the storage battery is estimated by calculating the circuit parameters which become the variables through the fitting calculation. Furthermore, for example, a full charge capacity of a storage battery is estimated using a machine learning model which outputs a full charge capacity of a storage battery in response to input of frequency characteristics of an impedance of the storage battery. In such a case, the measurement results regarding the frequency characteristics of impedance are input to the machine learning model, and the full charge capacity of the storage battery is estimated on the basis of results of the output from the machine learning model.

As described above, in a case of diagnosing a deterioration state of a storage battery, it is desired to reduce the effort in analyzing measurement data including measurement results of temporal changes in current and voltage of the storage battery by, for example, omitting the Fourier analysis of the measurement results of the temporal changes in current and voltage of the storage battery and the fitting calculation using the measurement results regarding the frequency characteristics of the impedance of the storage battery and an equivalent circuit model. It is also desired to reduce a time required for analyzing the measurement data by reducing the effort in analyzing temporal changes in current and voltage of the storage battery.

### CITATION LIST

### PATENT LITERATURE

PATENT LITERATURE 1: Jpn. Pat. Appln. KOKAI Publication No. 2020-20604
PATENT LITERATURE 2: Jpn. Pat. Appln. KOKAI Publication No. 2016-90346
PATENT LITERATURE 3: Jpn. Pat. Appln. KOKAI Publication No. 2014-126532
PATENT LITERATURE 4: Jpn. Pat. Appln. KOKAI Publication No. 2017-106889

### SUMMARY

### TECHNICAL PROBLEM

The problem to be solved by the present invention is to provide a diagnosis apparatus, a diagnosis system, and a diagnosis method of a storage battery which reduce the effort in analyzing measurement data including measurement results regarding temporal changes in current and voltage of the storage battery.

### SOLUTION TO PROBLEM

According to an embodiment, a diagnosis apparatus of a storage battery includes a processing circuit, and the processing circuit measures temporal changes in current and voltage of the storage battery in a state in which a pseudo-random pulse signal of current is input to the storage battery. By using a machine learning model which outputs an internal state of the storage battery in response to input of electrical characteristic data based on current time series data and voltage time series data of the storage battery, the processing circuit inputs target electrical characteristic data based on a measurement result regarding the temporal changes in the current and the voltage as the electrical characteristic data to the machine learning model. The processing circuit estimates the internal state of the storage battery on a basis of a result of outputting from the machine learning model in response to the input of the target electrical characteristic data.

### BRIEF DESCRIPTION OF THE DRAWINGS

FIG. 1 is a block diagram schematically showing an example of a diagnosis system according to a first embodiment.
FIG. 2 is a flowchart schematically showing an example of processing performed by a processing execution section in measurement of diagnostic measurement data of a storage battery in the first embodiment.
FIG. 3 is a schematic diagram showing an example of a pseudo-random pulse signal of current input to the storage battery in the first embodiment.
FIG. 4 is a schematic diagram illustrating an example of processing performed by the processing execution section in analysis of diagnostic measurement data of the storage battery in the first embodiment.
FIG. 5 is a flowchart schematically showing an example of processing performed by the processing execution section in the data processing in S111 of FIG. 4
FIG. 6 is a schematic diagram illustrating an example of processing in S122 and S123 of FIG. 5.
FIG. 7 is a schematic diagram showing an example of a machine learning model for use in processing in S112 of FIG. 4.
FIG. 8 is a schematic diagram illustrating an example of an equivalent circuit model of the storage battery according to the first embodiment.
FIG. 9 is a schematic diagram showing an example of training data for use in generation of a machine learning model in the first embodiment.
FIG. 10 is a schematic diagram showing an example of a plurality of machine learning models which are usable by a processing execution section in a first modification.
FIG. 11 is a schematic diagram illustrating an example of processing performed by the processing execution section in analysis of diagnostic measurement data of a storage battery in the first modification.

### DETAILED DESCRIPTION

Hereinafter, embodiments will be described with reference to the drawings.

### (First Embodiment)

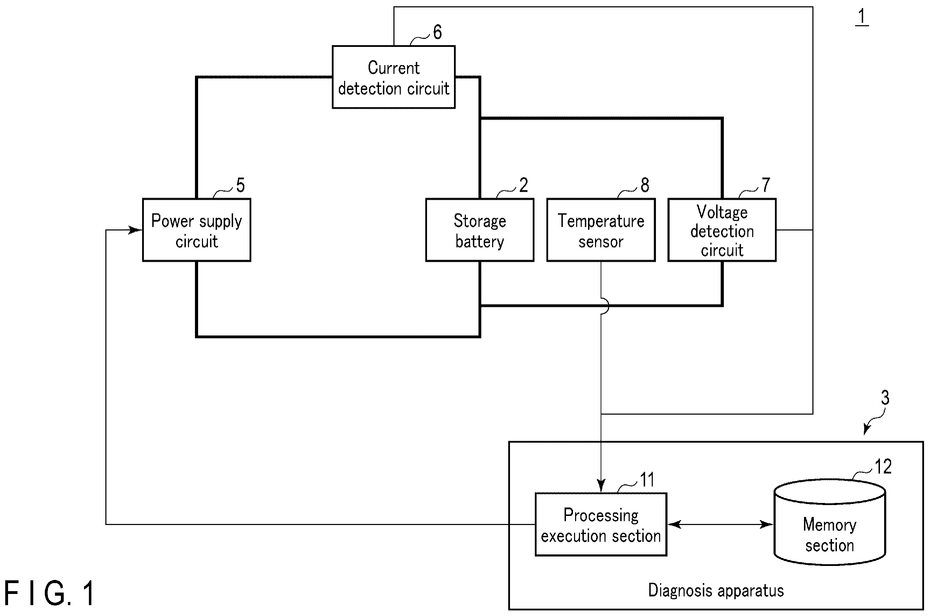

First, a first embodiment will be described as an example of an embodiment. FIG. 1 shows an example of a diagnosis system 1 according to the first embodiment. As shown in FIG. 1, the diagnosis system 1 includes a storage battery 2 to be diagnosed and a diagnosis apparatus 3. The storage battery 2 is mounted on, for example, a battery mounting device (not shown). Examples of the battery mounting device on which the storage battery 2 is mounted include a factory transport vehicle such as an automatic guided vehicle (AGV), a stationary power supply device, a smartphone, a vehicle such as an electric vehicle, a robot, a drone, etc.

The storage battery 2 is, for example, a secondary battery such as a lithium ion secondary battery. The storage battery 2 may be formed from a single cell (single battery), or may be a battery module or a cell block formed by electrically connecting a plurality of single cells. In a case where the storage battery 2 is formed from a plurality of single cells, the plurality of single cells may be electrically connected in series or may be electrically connected in parallel in the storage battery 2. Furthermore, in the storage battery 2, a series connection structure in which a plurality of single cells are connected in series and a parallel connection structure in which a plurality of single cells are connected in parallel may be both formed. Furthermore, the storage battery 2 may be either a battery string or a battery array in which a plurality of battery modules are electrically connected.

The diagnosis system 1 includes a power supply circuit 5, a current detection circuit 6, a voltage detection circuit 7, and a temperature sensor 8. The power supply circuit 5 is capable of outputting power to the storage battery 2. In one example, the power supply circuit 5 is used only in diagnosis of the storage battery 2. In another example, the power supply circuit 5 is used for charge of the storage battery 2 in addition to diagnosis of the storage battery 2. In such a case, an output state of power from the power supply circuit 5 in diagnosis of the storage battery 2 differs from an output state of power from the power supply circuit 5 in charge of the storage battery 2. The current detection circuit 6 detects current I flowing through the storage battery 2 and detects, for example, an input current to the storage battery 2. The voltage detection circuit 7 detects voltage V applied to the storage battery 2 and detects, for example, a voltage between the terminals of the storage battery 2. The temperature sensor 8 detects a temperature T of the storage battery 2. Therefore, the current detection circuit 6, the voltage detection circuit 7, and the temperature sensor 8 constitute a detection unit configured to detect parameters related to the storage battery 2.

The diagnosis apparatus 3 diagnoses a deterioration state, etc., of the storage battery 2 to be diagnosed. In the example shown in FIG. 1, the diagnosis apparatus 3 is a processing device (computer) such as a server, and includes a processing execution section 11 such as a processing circuit, and a memory section 12. In a case where the diagnosis apparatus 3 is a server, etc., the diagnosis apparatus 3 includes a processor or an integrated circuit, etc., and a non-transitory storage medium such as a memory. In the diagnosis apparatus 3, the processor or integrated circuit includes any one of a central processing unit (CPU), an application specific integrated circuit (ASIC), a graphics processing unit (GPU), a microcomputer, a field programmable gate array (FPGA), a digital signal processor (DSP), etc. The diagnosis apparatus 3 may be provided with only one processor or a plurality of processors. Furthermore, the diagnosis apparatus 3 may be provided with only one storage medium or a plurality of storage mediums. In the diagnosis apparatus 3, a processor or an integrated circuit, etc., performs processing by, for example, executing a program stored in the storage medium. Furthermore, in the diagnosis apparatus 3, processing of a processing execution section 11 which is a processing circuit is performed by a processor, etc., and a storage medium functions as the memory section 12. The processing execution section 11 performs processing to be described later by executing, for example, a diagnosis program stored in the memory section 12.

In one example, the diagnosis apparatus 3 is constituted of a plurality of processing devices (computers) such as a plurality of servers, and processors of the plurality of processing devices cooperate to perform processing to be described below by the processing execution section 11. Furthermore, in another example, a cloud server in a cloud environment constitutes at least a part of the diagnosis apparatus 3. The infrastructure of the cloud environment is constituted of a virtual processor such as a virtual GPU and a cloud memory. The virtual processor performs at least a part of the processing to be described later by the processing execution section 11. The cloud memory functions as the memory section 12.

Furthermore, in one example, the diagnosis system 1 may be provided with a user interface. In such a case, in the user interface, a user, etc., of the diagnosis system 1 inputs operations, etc., related to diagnosis of the diagnosis system 1. Therefore, the user interface is provided with any one of a button, a mouse, a touch panel, a keyboard, etc., as an operation section through which a user, etc., inputs operations. Furthermore, the user interface is also provided with a notification section configured to notify a user of information related to diagnosis of the diagnosis system 1. The notification section reports information by displaying the information on a screen or emitting a sound, etc. Meanwhile, the user interface may be mounted on a processing device constituting the diagnosis apparatus 3 or may be provided separately from the processing device constituting the diagnosis apparatus 3.

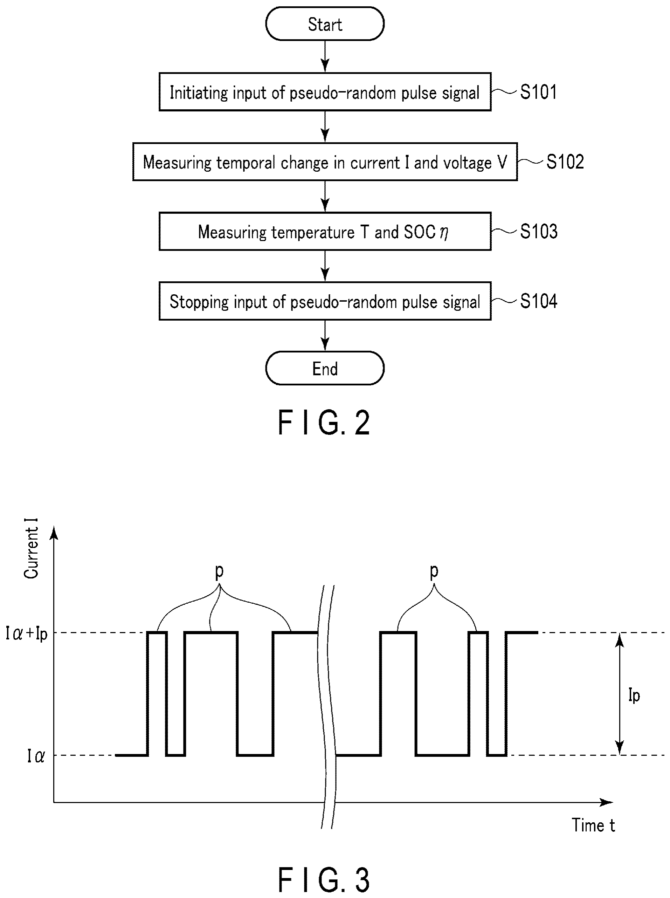

The diagnosis of the storage battery 2 to be diagnosed will be described below. In the present embodiment, the diagnosis of the storage battery 2 is performed periodically, and the following processing is performed each time diagnosis is performed. In diagnosis of the storage battery 2, the processing execution section 11 measures diagnostic measurement data of the storage battery 2. FIG. 2 is a flowchart showing an example of processing performed by the processing execution section 11 in measurement of diagnostic measurement data of the storage battery 2. Upon initiation of the example shown in FIG. 2, the processing execution section 11 initiates input of a pseudo-random pulse signal of the current I from the power supply circuit 5 to the storage battery 2 by controlling output from the power supply circuit 5 (S101).

In one example shown in FIG. 1, a pseudo-random pulse signal of current I is generated in the power supply circuit 5, and the power supply circuit 5 outputs the generated pseudo-random pulse signal to the storage battery 2. However, the pseudo-random pulse signal is not necessarily required to be generated in the power supply circuit 5. In one example, a driving circuit (switching circuit) is provided between the power supply circuit 5 and the storage battery 2, and the processing execution section 11 causes the power supply circuit 5 to output an output current to the storage battery 2 at a constant current value over time by controlling output from the power supply circuit 5. The driving circuit can be switched between a non-shunted state in which the entirety of output current from the power supply circuit 5 is input to the storage battery 2, and a shunted state in which a portion of the output current from the power supply circuit 5 is shunted and the shunted portion becomes a bypass current that is not input to the storage battery 2. The processing execution section 11 then inputs a pseudo-random pulse signal to the storage battery 2 by controlling switching of the driving circuit between a non-shunt state and a shunt state by controlling driving of the driving circuit.

FIG. 3 shows an example of a pseudo-random pulse signal of the current I input to the storage battery 2. In FIG. 3, the abscissa axis indicates time t and the ordinate axis indicates the current I. As shown in FIG. 3, a pseudo-random pulse signal of the current I input to the storage battery 2 includes a plurality of pulses p, and each of the plurality of pulses p is specified in terms of a pulse width and pulse height. At least one of the pulses p is different in pulse width from the other pulses p. Furthermore, the plurality of pulses p are also the same or approximately the same in terms of pulse height. Therefore, in the pseudo-random pulse signal input to the storage battery 2, an amplitude Ip of the current I is constant or approximately constant over time. In one example shown in FIG. 3, in the pseudo-random pulse signal, the current I varies over time between a current value (first current value) Iα and a current value (second current value) Iα+Ip that is greater than the current value Iα by an amplitude Ip. Meanwhile, the current value Iα may be zero or may be a value greater than zero.

As shown in FIG. 2, in measurement of diagnostic measurement data of the storage battery 2, the processing execution section 11 measures temporal changes in the current I and the voltage V of the storage battery 2 in a state in which a pseudo-random pulse signal of the current I is input to the storage battery 2 (S102). In a state in which a pseudo-random pulse signal is input to the storage battery 2, the current detection circuit 6 detects the current I of the storage battery 2 whereas the voltage detection circuit 7 detects the voltage V of the storage battery 2 at each of the plurality of time points which are different from each other. The processing execution section 11 measures temporal changes in the current I of the storage battery 2 based on a result of the detection by the current detection circuit 6 at the plurality of time points, and measures temporal changes of the voltage V of the storage battery 2 based on a result of the detection by the voltage detection circuit 7 at the plurality of time points. Meanwhile, in a state in which a pseudo-random pulse signal is input to the storage battery 2, temporal changes of the pseudo-random pulse signal shown in one example in FIG. 3 are measured as a measurement result Itar(t) regarding temporal changes of the current I of the storage battery 2.

Furthermore, in one example shown in FIG. 2, the processing execution section 11 measures the temperature T and SOCη of the storage battery 2 in addition to the temporal changes in the current I and the voltage V of the storage battery 2 (S103). In one example, the temperature sensor 8 detects the temperature T of the storage battery 2 during a period in which a pseudo-random pulse signal is input to the storage battery 2 or at a certain time point immediately before or after that period. The processing execution section 11 then calculates a value of the temperature T detected by the temperature sensor 8 as a measurement result Ttar regarding the temperature T of the storage battery 2. In another example, the temperature sensor 8 detects the temperature T of the storage battery 2 at each of the plurality of time points which are different from each other in a state in which a pseudo-random pulse signal is input to the storage battery 2. The processing execution section 11 calculates an average or median value of the values of the temperature T detected by the temperature sensor 8 at the plurality of time points, as the measurement result Ttar regarding the temperature T of the storage battery 2.

Furthermore, in measurement of the SOCη of the storage battery 2, the processing execution section 11 measures an open circuit voltage (OCV) of the storage battery 2 at the time of diagnosis, based on results of the detections by the current detection circuit 6 and the voltage detection circuit 7, in a state in which a pseudo-random pulse is input to the storage battery 2. At this time, the processing execution section 11 measures a closed-circuit voltage (CCV) of the storage battery 2 at the time of diagnosis from a result of the detection by the voltage detection circuit 7, and calculates the open circuit voltage of the storage battery 2 using a result of the measurement of the closed circuit voltage, a result of the detection by the current detection circuit 6, and a resistance component of the storage battery 2. Furthermore, a resistance component of the storage battery 2 for use in calculation of the open circuit voltage is calculated based on, e.g., a result of the estimation of the resistance component of the storage battery 2 in the previous diagnosis. The processing execution section 11 calculates a value of the SOCη of the storage battery 2 at the time of diagnosis as the measurement result ηtar of the SOCη, based on a result of the measurement regarding the open circuit voltage of the storage battery 2 and a relationship between the open circuit voltage of the storage battery 2 and the SOCη stored in the memory section 12. Meanwhile in one example, a value of the SOCη of the storage battery 2 at the time of diagnosis is calculated as the measurement result ηtar regarding the SOCη, based on, e.g., a value of the SOCη of the storage battery 2 at a predetermined time point before the diagnosis and a time history of charge and discharge of the storage battery 2 from the predetermined time point to the time of diagnosis. Furthermore, in another example, the processing execution section 11 may receive information on the SOC of the storage battery 2 from the power supply circuit 5 or the storage battery 2.

By measuring the measurement data as described above, the measured measurement data includes measurement results Itar(t) and Vtar(t) regarding temporal changes in the current I and the voltage V of storage battery 2 which are measured in a state in which a pseudo-random pulse signal is input to the storage battery 2. Furthermore, in the example shown in FIG. 2, the measured measurement data includes the measurement results Ttar and ηtar regarding the temperature T and the SOCη of the storage battery 2 measured during diagnosis. In a case where temporal changes of each of the current I and the voltage V of the storage battery 2, and the temperature T and the SOCη of the storage battery 2, etc. are measured as described above, the processing execution section 11 stops input of a pseudo-random pulse signal of the current I from the power supply circuit 5 to the storage battery 2 (S104) by controlling output from the power supply circuit 5. By this, the processing as an example shown in FIG. 2 is terminated.

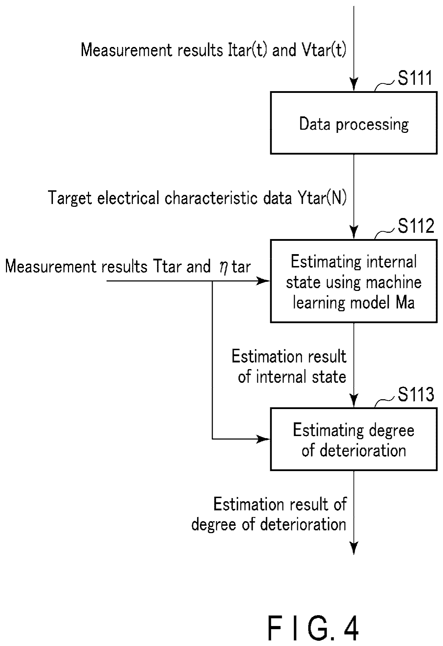

Furthermore, in diagnosis of the storage battery 2, the processing execution section 11 analyzes diagnostic measurement data of the storage battery 2 measured as described above. FIG. 4 illustrates an example of processing performed by the processing execution section 11 in analysis of the diagnostic measurement data of the storage battery 2. As shown in FIG. 4, in the present embodiment, in analysis of the measurement data, the processing execution section 11 performs data processing using the measurement results Itar(t) and Vtar(t) regarding temporal changes in the current I and the voltage V of the storage battery 2 contained in the measurement data (S111). The processing execution section 11 generates, through data processing in S111, the target electrical characteristic data Ytar(N) of the storage battery 2 which is based on the measurement results Itar(t) and Vtar(t) regarding temporal changes in the current I and the voltage V of the storage battery 2.

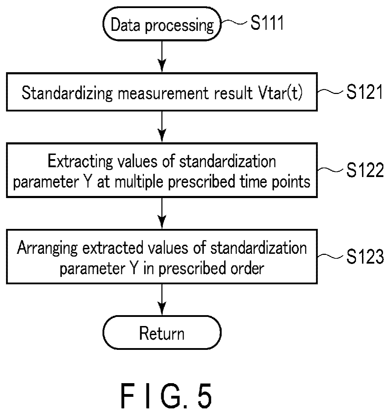

FIG. 5 shows, in the form of a flowchart, an example of processing performed by the processing execution section 11 in the data processing in S111 shown in FIG. 4, that is, generation of the target electrical characteristic data Ytar(N) of the storage battery 2. Upon initiation of processing in an example shown in FIG. 5, the processing execution section 11 standardizes the measurement result Vtar(t) regarding temporal changes in the voltage V using the amplitude Ip of the current I in temporal changes in the measured current I (S121). At this time, the processing execution section 11 standardizes the measurement result Vtar(t) regarding temporal changes in the voltage V by, for example, dividing, by the amplitude Ip of current I, a measurement value of the voltage V at each of a plurality of time points indicated by the measurement result Vtar(t) regarding temporal changes in the voltage V. The processing execution section 11 standardizes the measurement result Vtar(t) for temporal changes in voltage, thereby generating standardization time series data Ytar(t) for the storage battery 2 to be diagnosed. The standardization time series data Ytar(t) indicates a value of a standardization parameter Y for each of the time points at which the current I and the voltage V of the storage battery 2 are measured (detected) in measurement of the measurement data. The standardization parameter Y corresponds to a parameter obtained by dividing the voltage V of the storage battery 2 by the amplitude Ip of the current I in temporal changes in the measured current I.

The processing execution section 11 extracts values of the standardization parameter Y at a plurality of prescribed time points which are mutually different from each other, from the generated standardization time series data Ytar(t) (S122). The number of prescribed time points extracted from the standardization time series data Ytar(t) is smaller than the number of time points at which the current I and the voltage V of the storage battery 2 are measured in measurement of the measurement data. The processing execution section 11 arranges values of the standardization parameter Y at the plurality of extracted prescribed time points in a prescribed order (S123). At this time, the prescribed order in which the values at the plurality of prescribed time points are arranged is set based on an order parameter N.

By performing processing in S122 and S123 as described above, the processing execution section 11 generates the target electrical characteristic data Ytar(N) of the storage battery 2 to be diagnosed. Since the target electrical characteristic data Ytar(N) of the storage battery 2 is generated as described above, in the target electrical characteristic data Ytar(N), the extracted values of the standardization parameter Y at the plurality of prescribed time points are presented in a state in which these extracted values are arranged in a prescribed order based on the order parameter N. Furthermore, since the target electrical characteristic data Ytar(N) is generated as described above, the target electrical characteristic data Ytar(N) is data based on the measurement results Itar(t) and Vtar(t) regarding temporal changes in the current I and the voltage V of the storage battery 2 contained in the measurement data. Furthermore, the number of data points at which a value of the standardization parameter Y is presented in the standardization time series data Ytar(t) is equal to the number of time points at which the current I and the voltage V of the storage battery 2 are measured in measurement of the measurement data, and the number of data points at which a value of the standardization parameter Y is presented in the target electrical characteristic data Ytar(N) is equal to the number of prescribed time points extracted from the standardization time series data Ytar(t). Therefore, the number of data points at which a value of the standardization parameter Y is presented in the target electrical characteristic data Ytar(N) is decreased from the number of data points at which a value of the standardization parameter Y is presented in the standardization time series data Ytar(t).

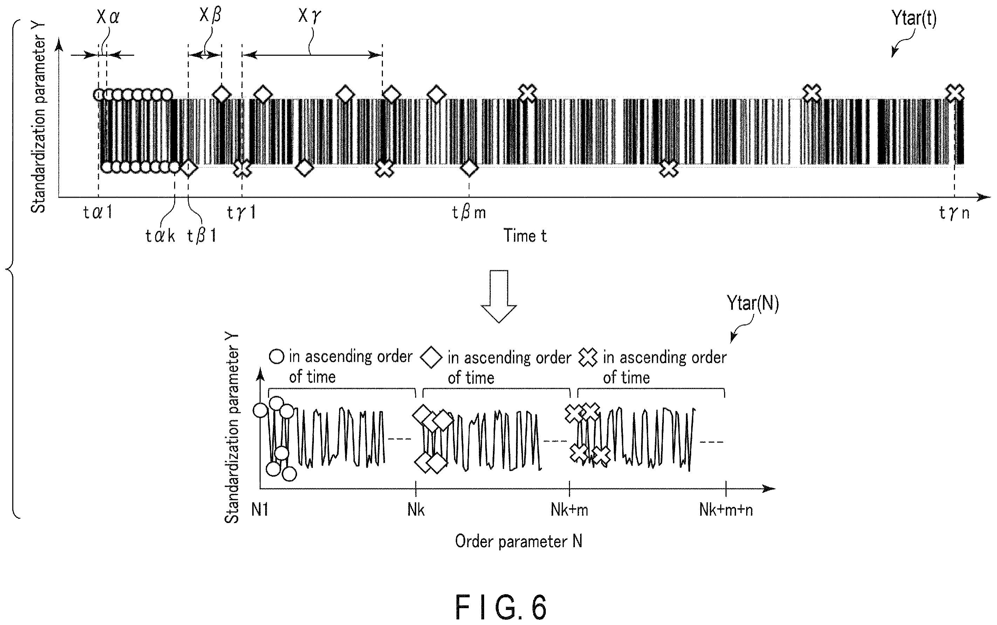

FIG. 6 illustrates an example of the processing in S122 and S123 in FIG. 5. In FIG. 6, the standardization time series data Ytar(t) described above is shown in the form of a graph in which the abscissa axis represents time t and the ordinate axis indicates the standardization parameter Y, and the target electrical characteristic data Ytar(N) described above is shown in the form of a graph in which the abscissa axis indicates the order parameter N and the ordinate axis presents the standardization parameter Y. In an example shown in FIG. 6, the processing execution section 11 extracts values indicated by white circles, values indicated by white diamonds, and values indicated by white crosses, as values of the standardization parameter Y at a plurality of prescribed time points, through the processing in S122.

The values indicated by the white circles are extracted by extracting values of the standardization parameter Y at equal time intervals (first time intervals) Xα between a time tα1 and a time tαk (where k is an integer equal to or greater than 2) later than the time tα1. Furthermore, the values indicated by the white diamonds are extracted by extracting values of the standardization parameter Y at equal time interval intervals (second time intervals) Xβ, the time interval Xβ being longer than time interval Xα, between a time tβ1 and a time tβm (where m is an integer equal to or greater than 2) later than the time tβ1. The values indicated by the white crosses are extracted by extracting values of the standardization parameter Y at equal time intervals (third time intervals) Xγ, the time interval Xγ being longer than time interval Xβ, between a time tγ1 and a time tγk (where n is an integer equal to or greater than 2) later than the time tγ1. In an example shown in FIG. 6, each of the times tβ1 and tγ1 is a time point later than the time tαk, and the time tγ1 is a time point between the time tβ1 and the time tβm. Furthermore, the time tγn is a time point later than the time tβm.

Furthermore, in example 6, through the processing in S123, the processing execution section 11 arranges the values indicated by the white circles in ascending order of time t, and arranges the values indicated by the white diamonds in ascending order of time t on the side greater in order parameter N than the values indicated by the white circles. The processing execution section 11 then arranges the values indicated by the white crosses in ascending order of time t on the side greater in order parameter N than the values indicated by the white diamonds. Therefore, in the target electrical characteristic data Ytar(N), the values of the standardization parameter Y are arranged in the order of time tα1, ..., tαk from the side in which the order parameter N is smaller, and the values of the standardization parameter Y are arranged in the order of time tβ1, ..., tβm from the side in which the order parameter N is smaller, on the side greater in order parameter N than the values of the standardization parameter Y between the time tα1 and the time tαk. In the target electrical characteristic data Ytar(N), the values of the standardization parameter Y are arranged in the order of time tγ1, ..., tγn, from the side in which the order parameter N is smaller, on the side greater in order parameter N than the values of the standardization parameter Y between the time tβ1 and the time tβm. Therefore, in the target electrical characteristic data Ytar(N), the values of the standardization parameter Y at the order parameters N1 to Nk, Nk+1 to Nk+m, and Nk+m+1 to Nk+m+n respectively correspond to the values of the standardization parameter Y at times tα1 to tαk, tβ1 to tβm, and tγ1 to tγn of the standardization time series data Ytar(t).

In the example shown in FIG. 6, the times tα1, tβ1, and tγ1 are time points which are different from each other; however, in an example, the times tα1, tβ1, and tγ1 may be time points which are identical to each other. In such a case as well, values of the standardization parameter Y are extracted at equal time intervals Xα between the time tα1 and the time tαk, values of the standardization parameter Y are extracted at equal time intervals Xβ each longer than the time interval Xα between the time tβ1 and the time tβm, and values of the standardization parameter Y are extracted at equal time intervals Xγ each longer than the time interval Xβ between the time tγ1 and the time tγn. Furthermore, in a case where the times tα1, tβ1, and tγ1 are time points which are identical to each other, each of the times tα1, tβ1, and tγ1 may serve as a start point of input of a pseudo-random pulse signal of current to the storage battery 2.

As shown in FIG. 4, in analysis of the diagnostic measurement data, the processing execution section 11 uses a machine learning model Ma to estimate an internal state of the storage battery 2 from the target electrical characteristic data Ytar(N) of the storage battery 2 and the measurement results Ttar and ηtar of the temperature T and the SOCη of the storage battery 2 indicated by the measurement data (S112). The machine learning model Ma used in S112 is stored in the memory section 12 and is generated (constructed) as described below.

The processing execution section 11 inputs, to the machine learning model Ma, the target electrical characteristic data Ytar(N) based on measurement results Itar(t) and Vtar(t) regarding temporal changes in the current I and the voltage V of the storage battery 2, and the measurement results Ttar and ηtar regarding the temperature T and the SOCη of the storage battery 2. As a result, the machine learning model Ma outputs the internal state of the storage battery 2 corresponding to the input target electrical characteristic data Ytar(N) and the measurement results Ttar and ηtar. At this time, the machine learning model Ma outputs, as the internal state of the storage battery 2, a value of a parameter indicating the internal state of the storage battery 2, for example, a value of a circuit parameter ε set in an equivalent circuit model of the storage battery 2 including a resistance component of the storage battery 2. The processing execution section 11 estimates the internal state of the storage battery 2 based on a result of output from the machine learning model Ma. In an example, the processing execution section 11 estimates the resistance component of the storage battery 2 as the internal state of the storage battery 2, on the basis of the value of the circuit parameter ε output from the machine learning model Ma. For example, a value of the resistance component of the storage battery 2 output from the machine learning model Ma as a value of the circuit parameter ε is estimated as a value of the resistance component of the storage battery 2 in real time.

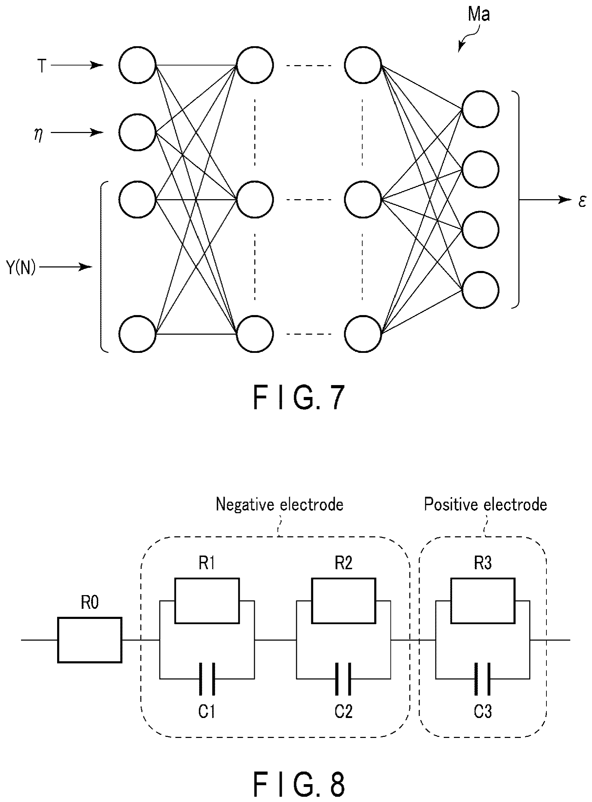

FIG. 7 shows an example of the machine learning model Ma used in the processing in S112 shown in FIG. 4. As shown in FIG. 7, the electrical characteristic data Y(N) of the storage battery 2, such as the target electrical characteristic data Ytar(N) described above, is input to an input layer of the machine learning model Ma. The electrical characteristic data Y(N) is data based on current time series data I(t) and voltage time series data V(t) of the storage battery 2. The current time series data I(t) indicates temporal changes in the current I of the storage battery 2 in a state in which a pseudo-random pulse signal of the current I is input to the storage battery 2, as with the measurement result Itar(t) of temporal changes in the current I contained in the measurement data, and the voltage time series data V(t) indicates temporal changes in the voltage V of the storage battery 2 in a state in which a pseudo-random pulse signal of the current I is input to the storage battery 2, as with the measurement result Vtar(t) of temporal changes in the voltage V contained in the measurement data. The electrical characteristic data Y(N) is generated on the basis of the current time series data I(t) and the voltage time series data V(t) in a manner similar to generation of the target electrical characteristic data Ytar(N) using the measurement results Itar(t) and Vtar(t) regarding temporal changes in the current I and the voltage V of the storage battery 2 contained in the measurement data.

By the electrical characteristic data Y(N) being input to the machine learning model Ma, a value of the standardization parameter Y is input to the machine learning model Ma for each value of the order parameter N. For example, by the target electrical characteristic data Ytar(N) generated as in the example shown in FIG. 6 being input as the electrical characteristic data Y(N) to the machine learning model Ma, a value of the standardization parameter Y for each of the order parameters N1 to Nk+m+n is input to the machine learning model Ma. Furthermore, the temperature T and the SOCη of the storage battery 2, such as the measurement results Ttar and ηtar indicated by the measurement data, are input to the input layer of the machine learning model Ma. In the machine learning model Ma, by the electrical characteristic data Y(N), etc., being input, processing is performed in an intermediate layer, and values of parameters indicating the internal state of the storage battery 2, such as values of the circuit parameter ε of the equivalent circuit model of the storage battery 2, are output from an output layer. In an example, a plurality of circuit parameters ε are set in the equivalent circuit model of the storage battery 2, and the electrical characteristic data Y(N) etc., are input, so that the machine learning model Ma outputs a value for each of the plurality of circuit parameters ε.

FIG. 8 illustrates an example of the equivalent circuit model of the storage battery 2. In an example of the equivalent circuit model shown in FIG. 8, resistances R0, R1, R2, and R3, which serve as resistance components, and capacitances C1, C2, and C3, which serve as capacitance components, are set as the circuit parameters ε. In the example shown in FIG. 8, the resistances R1 and R2 serve as resistance components of a negative electrode of the storage battery 2, and the resistance R3 serves as a resistance component of a positive electrode of the storage battery 2. In an example, by the electrical characteristic data Y(N), etc., being input, the machine learning model Ma outputs a value for each of the resistances R0 to R3 and capacitances C1 to C3, which are the circuit parameters ε. An equivalent circuit model of the storage battery and circuit parameters set in the equivalent circuit model are disclosed, e.g., in Patent Literature 4 (Jpn. Pat. Appln. KOKAI Publication No. 2017-106889).

Furthermore, the machine learning model Ma used in the processing in S112 is generated (constructed) using training data composed of a large number of datasets. Each dataset of the training data indicates, for example, data from past diagnoses of a storage battery similar to the storage battery 2 to be diagnosed. Each dataset indicates electrical characteristic data Y(N) similar to the target electrical characteristic data Ytar(N). The electrical characteristic data Y(N) indicated by each dataset is generated, for example, on the basis of the current time series data I(t) and the voltage time series data V(t) which were measured in a past diagnosis in a state in which a pseudo-random pulse signal of current I was input. At this time, the electrical characteristic data Y(N) of each dataset is generated in a similar manner to generation of the target electrical characteristic data Ytar(N) using the measurement results Itar(t) and Vtar(t) regarding temporal changes in the current I and the voltage V of the storage battery 2 contained in the measurement data.

Furthermore, each dataset indicates values of temperature T and the SOCη. In each dataset, for example, measurement values in a past diagnosis of a storage battery similar to storage battery 2 are indicated as the values of temperature T and SOC η. The values of the temperature T and the SOCη indicated by each dataset are measured in a manner similar to the above-described measurement of the temperature T and the SOCη of storage battery 2. Furthermore, each dataset indicates a value of circuit parameter ε of the equivalent circuit model. In generation of each dataset, a value of the circuit parameter ε is calculated using the aforementioned current time series data I(t) and voltage time series data V(t) measured in a state in which a pseudo-random pulse signal of current I is input.

In generation of each dataset, by performing Fourier analysis on the current time series data I(t) and the voltage time series data V(t) in calculation of a value of the circuit parameter ε, the impedance of the storage battery is measured at each of the plurality of frequencies and the frequency characteristics of the impedance of the storage battery are measured. A measurement result of the frequency characteristic of the impedance of the storage battery can be represented, for example, in a complex impedance plot (Cole-Cole plot). Meanwhile, a method of calculating the frequency characteristic of the impedance of the storage battery using current time series data and voltage time series data of the storage battery is disclosed in Patent Literature 3 (Jpn. Pat. Appln. KOKAI Publication No. 2014-126532). In the embodiment, etc., in generation of each dataset, the frequency characteristics of the impedance of the storage battery may be calculated as with Patent Literature 3.

In generation of each dataset of training data, a value of the circuit parameter ε is calculated using the measurement results of the impedance frequency characteristics and the equivalent circuit model of the storage battery. Herein, the equivalent circuit model indicates an arithmetic expression, etc., for calculating the impedance of the storage battery from the set circuit parameter ε, and indicates, for example, an equation for calculating the real component and the imaginary component of the impedance of the storage battery using the circuit parameter ε and a frequency, etc. In generation of each dataset, in calculation of a value of the circuit parameter ε, fitting calculation is performed using the aforementioned arithmetic expression indicated by the equivalent circuit model and the measurement result of the frequency characteristics of the impedance of the storage battery. At this time, the fitting calculation is performed using the circuit parameter ε of the equivalent circuit model as a variable, and the circuit parameter ε serving as the variable is calculated. Furthermore, in the fitting calculation, for example, a value of the circuit parameter ε which serves as a variable is determined such that a difference between an impedance calculation result using the arithmetic expression indicated by the equivalent circuit model and an impedance measurement result is as small as possible at each frequency at which the impedance is measured. Meanwhile, Patent Literature 4 discloses a method of performing fitting calculations using measurement results of the frequency characteristics of the impedance of a storage battery and an equivalent circuit model of the storage battery to calculate circuit parameters of the equivalent circuit model.

Since the training data is constructed as described above, in each of the plurality of datasets of the training data, for a storage battery similar to the storage battery 2 diagnosed in the past, a parameter indicating the internal state of the storage battery, such as the circuit parameter ε, is associated with the electrical characteristic data Y(N) based on the current time series data I(t) and the voltage time series data V(t). Furthermore, in each dataset, for a storage battery similar to the storage battery 2 diagnosed in the past, a parameter indicating the internal state of the storage battery, such as the circuit parameter ε, is associated with the temperature T and the SOCη.

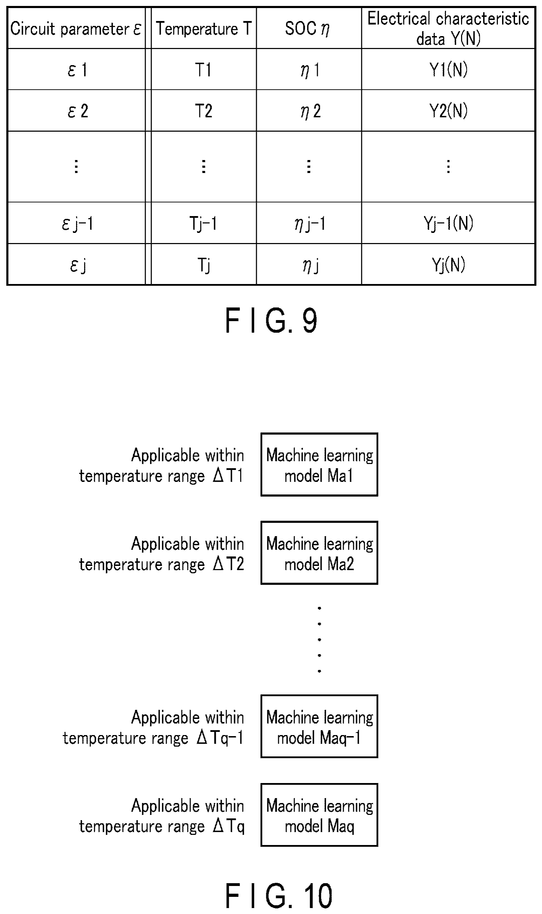

FIG. 9 shows an example of training data for use in generation of the machine learning model Ma. In the example shown in FIG. 9, the training data is composed of j datasets (where j is an integer equal to or greater than 2). In the example of the training data in FIG. 9, in j datasets, values of parameter sets ε1 to εj of the circuit parameters ε are respectively associated with the electrical characteristic data Y1(N) to Yj(N). In j datasets, values of the parameter sets ε1 to εj of the circuit parameters ε are respectively associated with values T1 to Tj of the temperature T and values η1 to ηj of the of the SOCη.

In generation of the machine learning model Ma, a model is trained, through deep learning, by using a portion of many datasets of training data as training datasets. In such a case, for example, a neural network is trained as a model. Furthermore, the model is trained through supervised learning in which a value of the circuit parameter ε indicated by each training dataset is given as a correct answer. Through deep learning, the model learns the association of parameters indicating the internal state of the battery, such as the circuit parameter ε with respect to the electrical characteristic data Y(N), the temperature T, and the SOCη, indicated by the training dataset.

Upon completion of the learning using the training dataset, a portion of the training dataset is used as an evaluation dataset to evaluate the learned model. In model evaluation, the electrical characteristic data Y(N) and the respective values of the temperature T and SOC η for each of the evaluation datasets are input to the learned model. For each evaluation dataset, a value of the circuit parameter ε output as a result of output from the trained model is compared with a calculation result of the circuit parameter ε in diagnosis which was actually performed in the past. By performing the above comparison for each training dataset, the validity of a result of output from the model with respect to the calculation result in the actual diagnosis is determined.

If the validity of a result of the output from the model with respect to the calculation result in the actual diagnosis is equal to or higher than a reference level, the trained model is stored as the machine learning model Ma in the memory section 12. On the other hand, if the validity of a result of the output from the model with respect to the calculation result in the actual diagnosis is lower than the reference level, a training dataset is added and the model is trained using the added training dataset in a manner described above. The training of the model using the training dataset and the evaluation of the model using the evaluation dataset are repeatedly performed until the validity of a result of the output from the model with respect to the calculation result in actual diagnosis reaches or exceeds the reference level in the model evaluation.

In analysis of the diagnostic measurement data shown as an example in FIG. 4, the processing execution section 11 estimates the degree of deterioration of the storage battery 2 on the basis of the internal state of the storage battery 2 including the circuit parameter ε estimated using the machine learning model Ma (S113). In estimation of the degree of deterioration, the processing execution section 11 calculates a ratio ξ of a resistance of the positive electrode to a resistance of the negative electrode of the storage battery 2 on the basis of the estimation result of the resistance component of the storage battery 2 set as the circuit parameter ε. Herein, it is assumed that, using the machine learning model Ma, each of the values of the resistances R0 to R3 and the capacitances C1 to C3 indicted as the circuit parameters ε in the example of the equivalent circuit model shown in FIG. 8 are estimated as the internal state of the storage battery 2 in S112. In such a case, the processing execution section 11 calculates the ratio ξ while the sum of the values of the resistances R1 and R2 is set to a resistance of the negative electrode and the value of the resistance R3 is set to a resistance of the positive electrode.

The processing execution section 11 then estimates the degree of deterioration of the storage battery 2 on the basis of the calculated ratio ξ. At this time, as a change in the ratio ξ of the resistance of the positive electrode to the resistance of the negative electrode from the start of use of the storage battery 2 becomes larger, the degree of deterioration of the storage battery 2 is determined to be higher. The estimation of the degree of deterioration in S113 may be performed based on the measurement results Ttar and ηtar, etc., of the temperature T and the SOCη of the storage battery 2 in addition to the ratio ξ described above. In such a case, for example, on the basis of the measurement results Ttar and ηtar, etc., of the temperature T and the SOCη of the storage battery 2, the processing execution section 11 corrects a calculated value of the ratio ξ of the resistance of the positive electrode to the resistance of the negative electrode calculated as described above, to a corrected value at a reference temperature Tref and a reference SOC ηref. The processing execution section 11 estimates the degree of deterioration of the storage battery 2 on the basis of the corrected value of the ratio ξ after correction. Furthermore, the processing in S113 may not necessarily be performed. In such a case, upon estimation of the internal state of the storage battery 2 such as the circuit parameter ε in S112, the processing of analyzing the diagnostic measurement data is terminated.

As described above, in the present embodiment, the processing execution section 11 serving as a processing circuit measures temporal changes in the current I and the voltage V of the storage battery 2 in a state in which a pseudo-random pulse signal of the current I is input to the storage battery 2. By using the machine learning model Ma, which outputs the internal state of the storage battery 2 in response to input of electrical characteristic data Y(N) based on the current time series data I(t) and the voltage time series data V(t) of the storage battery 2, the processing execution section 11 inputs, as the electrical characteristic data Y(N), the target electrical characteristic data Ytar(N) on the basis of the measurement results Itar(t) and Vtar(t) of temporal changes in the current I and the voltage V to the machine learning model Ma. The processing execution section 11 then estimates the internal state of the storage battery 2 on the basis of a result of the output from the machine learning model Ma in response to input of the target electrical characteristic data Ytar(N). Since the internal state of the storage battery 2 is estimated as described above, the internal state of the storage battery 2 is estimated without performing the Fourier analysis on the measurement results Itar(t) and Vtar(t) regarding temporal changes in the current I and the voltage V of the storage battery 2, or the fitting calculation using the measurement result regarding the frequency characteristics of the impedance of the storage battery 2 and the equivalent circuit model. This reduces the effort in analyzing the measurement data including the measurement results Itar(t) and Vtar(t) regarding the temporal changes in the current I and the voltage V of the storage battery 2. This also achieves a reduction in time required to analyze the measurement data.

Furthermore, in the present embodiment, the processing execution section 11 generates, in the data processing in S111, the standardization time series data Ytar(t) by standardizing the measurement result Vtar(t) regarding a time change in the voltage V using the amplitude Ip of the measured current I in the time change in the current I. The processing execution section 11 generates the target electrical characteristic data Ytar(N) to be input to the machine learning model Ma, by extracting values at a plurality of prescribed time points which are different from each other from the generated standardization time series data Ytar(t), and arranging the extracted values at the plurality of prescribed time points in a prescribed order. As a result, according to the present embodiment, the amount of data to be input to the machine learning model Ma is reduced, thereby reducing the amount of data to be processed using the machine learning model Ma as compared to a case in which the measurement results Itar(t) and Vtar(t) regarding temporal changes in the current I and the voltage V of the storage battery 2 are directly input to the machine learning model Ma.

Furthermore, in an example of the present embodiment, the machine learning model Ma outputs a circuit parameter ε set in the equivalent circuit model of the storage battery 2 including the resistance component of the storage battery 2 in response to input of the electrical characteristic data Y(N). The processing execution section 11 estimates the resistance component of the storage battery 2 as the internal state of the storage battery 2 on the basis of a result of the output from the machine learning model Ma in response to the input of the target electrical characteristic data Ytar(N). Therefore, by using the machine learning model Ma, the resistance component of the storage battery 2 is appropriately estimated as the internal state of the storage battery 2.

Furthermore, in an example of the present embodiment, the processing execution section 11 calculates a ratio ξ of a resistance of the positive electrode to a resistance of the negative electrode of the storage battery 2 on the basis of a result of the estimation of the resistance component of the storage battery 2. The processing execution unit then estimates the degree of deterioration of the storage battery 2 on the basis of the calculated ratio ξ. Therefore, the degree of deterioration of the storage battery 2 is appropriately estimated on the basis of, e.g., the amount of change in the ratio ξ of the resistance of the positive electrode to the resistance of the negative electrode from the start of use of the storage battery 2.

Furthermore, in an example of the present embodiment, the processing execution section 11 measures the temperature T and the SOCη of the storage battery 2 in diagnosis. The processing execution section 11 then estimates the internal state of the storage battery 2 by inputting the measurement results Ttar and ηtar regarding the temperature T and the SOCη of the storage battery 2 in addition to the target electrical characteristic data Ytar(N) to the machine learning model Ma. By this, the internal state of the storage battery 2 is appropriately estimated in consideration of the temperature T and the SOC η of the storage battery 2 in a state in which time changes in the current I and the voltage V are being measured.

### (Modification)

In a modification, the machine learning model Ma outputs parameters indicating the internal state of the storage battery 2, such as the circuit parameter ε, by inputting one of the temperature T and the SOC η in addition to the electrical characteristic data Y(N). In such a case, the processing execution section 11 estimates the internal state of the storage battery 2 by inputting, to the machine learning model Ma, one of the measurement results Ttar and ηtar regarding the temperature T and the SOCη in addition to the target electrical characteristic data Ytar(N) on the basis of the measurement results Itar(t) and Vtar(t) regarding temporal changes in the current I and the voltage V. Furthermore, in another modification, the machine learning model Ma outputs a parameter indicating the internal state of the storage battery 2, such as the circuit parameter ε, in response to input of only the electrical characteristic data Y(N). In such a case, the processing execution section 11 estimates the internal state of the storage battery 2 by inputting, to the machine leaning model Ma, only the target electrical characteristic data Ytar(N) based on the measurement results Itar(t) and Vtar(t) regarding temporal changes in the current I and the voltage V.

Even in the modifications described above, the internal state of the storage battery 2 is estimated without performing the Fourier analysis on the measurement results Itar(t) and Vtar(t) regarding temporal changes in the current I and the voltage V of the storage battery 2, or the fitting calculation using the measurement result regarding the frequency characteristics of the impedance of the storage battery 2 and the equivalent circuit model. This reduces the effort in analyzing measurement data including the measurement results Itar(t) and Vtar(t) regarding temporal changes in the current I and the voltage V of the storage battery 2. Furthermore, in the modifications also, the machine learning model Ma is generated (constructed) using training data composed of a large number of datasets and in each of the plurality of datasets of the training data, for a storage battery similar to the storage battery 2 diagnosed in the past, a parameter indicating the internal state of the storage battery, such as the circuit parameter ε, is associated with the electrical characteristic data Y(N) based on the current time series data I(t) and the voltage time series data V(t).

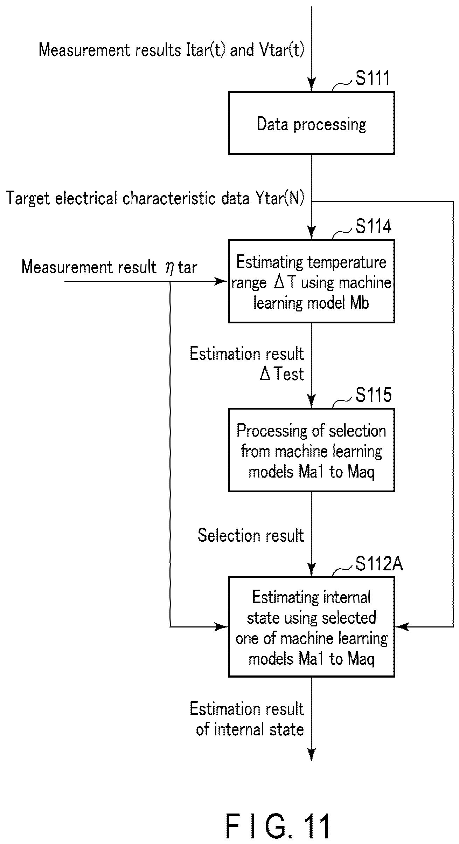

Furthermore, in the first modification shown in FIG. 10 and FIG. 11, the processing execution section 11 is capable of using a plurality of machine learning models Ma1 to Maq (where q is an integer greater than or equal to 2) as the machine learning model Ma which outputs the internal state of the storage battery 2 in response to input of the electrical characteristic data Y(N). FIG. 10 shows an example of the multiple machine learning models Ma1 to Maq which are usable by the processing execution section 11 in the present modification. In the present modification also, each of the machine learning models Ma1 to Maq outputs the internal state of the storage battery 2 in response to input of the electrical characteristic data Y(N) based on the current time series data I(t) and the voltage time series data V(t) of the storage battery 2.

Furthermore, in the present modification, in addition to the electrical characteristic data Y(N), the SOCη of the storage battery 2 is inputable to the input layer of each of the machine learning models Ma1 to Maq. The plurality of machine learning models Ma1 to Maq are different from each other in terms of applicable temperature range ΔT. In an example shown in FIG. 10, the applicable temperature ranges of the machine learning models Ma1, Ma2, ..., Maq are temperature ranges ΔT1, ΔT2, ..., ΔTq, respectively. Each of the machine learning models Ma1 to Maq is generated (constructed) using training data composed of a large number of datasets, similar to the machine learning model Ma, and in each of the large number of datasets, parameters indicating the internal state of the battery, such as a circuit parameter ε, are associated with electrical characteristic data Y(N) based on current time series data I(t) and voltage time series data V(t) for a previously diagnosed storage battery similar to a storage battery 2. However, each of the machine learning models Ma1 to Maq is generated using only a dataset which falls within the applicable temperature range ΔT described above.

FIG. 11 illustrates an example of processing performed by the processing execution section 11 in analysis of diagnostic measurement data of the storage battery 2 in the first modification. In the present modification also, the processing execution section 11 generates, through the processing in S111, the target electrical characteristic data Ytar(N) of the storage battery 2 which is based on the measurement results Itar(t) and Vtar(t) regarding temporal changes in the current I and the voltage V of the storage battery 2. In the present modification, the processing execution section 11 estimates the temperature range ΔT of the storage battery 2 from the target electrical characteristic data Ytar(N) of the storage battery 2 and the measurement result ηtar of the SOCη of the storage battery 2 indicated by the measurement data, using a machine learning model (additional machine learning model) Mb different from the machine learning models Ma1 to Maq (S114). The machine learning model Mb used in S114 is stored in the memory section 12. Furthermore, in the present modification, the temperature T of the storage battery 2 is not measured in measurement of the measurement data.

In the present modification, the processing execution section 11 inputs, to the machine learning model Mb, the target electrical characteristic data Ytar(N) based on measurement results Itar(t) and Vtar(t) regarding temporal changes in the current I and the voltage V of the storage battery 2, and the measurement result ηtar regarding the SOCη of the storage battery 2. By this, the machine learning model Mb outputs, as information on the temperature T of the storage battery 2, the temperature range ΔT of the storage battery 2 corresponding to the input target electrical characteristic data Ytar(N) and the measurement result ηtar. The processing execution section 11 estimates the temperature range ΔT of the storage battery 2 on the basis of a result of output from the machine learning model Mb. Therefore, the processing in S114 uses the machine learning model Mb which outputs information on the temperature T of the storage battery 2, such as the temperature range ΔT, in response to input of the electrical characteristic data Y(N), such as the target electrical characteristic data Ytar(N).

Furthermore, as with the machine learning models Ma1 to Maq, the machine learning model Mb is generated (constructed) using training data composed of a large number of datasets. However, in each dataset of training data for use in generation of the machine learning model Mb, information on the temperature T of the storage battery 2, such as the temperature range ΔT of the storage battery 2, is associated with the electrical characteristic data Y(N) based on the current time series data I(t) and the voltage time series data V(t). Furthermore, in generation of the machine learning model Mb, as with the generation of the machine learning model Ma, a model is trained by using a portion of the datasets as a training dataset. A portion of the datasets is then used as an evaluation dataset to evaluate the model as described above.

Furthermore, in the present modification, the processing execution section 11 performs processing of selection from the plurality of machine learning models Ma1 to Maq on the basis of an estimation result ΔTest regarding the temperature range ΔT estimated using the machine learning model (additional machine learning model) Mb (S115). By this, on the basis of a result of output from the machine learning model Mb in response to input of the target electrical characteristic data Ytar(N), one of the plurality of machine learning models Ma1 to Maq is selected to input thereto the target electrical characteristic data Ytar(N). At this time, a machine learning model (a corresponding one of Ma1 to Maq) which is applicable to the temperature range ΔT corresponding to the estimation result ΔTest is selected from the machine learning models Ma1 to Maq. That is, a machine learning model (a corresponding one of Ma1 to Maq) applicable to the temperature range ΔT indicated by the information regarding the temperature T of the storage battery 2 output from the machine learning model Mb is selected from the machine learning models Ma1 to Maq.

The processing execution section 11 then estimates, by using a selected one of the machine learning models Ma1 to Maq, the internal state of the storage battery 2 from the target electrical characteristic data Ytar(N) of the storage battery 2 and the measurement result ηtar of the SOCη of the storage battery 2 (S112A). At this time, as with the processing in S112 in the example shown in FIG. 4, the internal state of the storage battery 2 is estimated using the selected machine learning model (the corresponding one of Ma1 to Maq). That is, in the present modification, the processing execution section 11 inputs the target electrical characteristic data Ytar(N) and the measurement result ηtar regarding the SOCη of the storage battery 2 to the selected machine learning model (the corresponding one of Ma1 to Maq). As a result, the selected machine learning model (the corresponding one of Ma1 to Maq) outputs the internal state of the storage battery 2 corresponding to the input target electrical characteristic data Ytar(N) etc. The processing execution section 11 then estimates the internal state of the storage battery 2 on the basis of a result of output from the selected machine learning model (the corresponding one of Ma1 to Maq). Although not shown in FIG. 11, in the present modification, in a case where the processing execution section 11 estimates the internal state of the storage battery 2 through processing in S112A, it may estimate the degree of deterioration of the storage battery 2 in a manner similar to the example shown in FIG. 4.

Furthermore, in a modification, in an aspect in which the machine learning models Ma1 to Maq and the machine learning model Mb are usable as with the first modification, the plurality of machine learning models Ma1 to Maq are different from each other in terms of applicable SOC range Δη. Furthermore, in addition to the electrical characteristic data Y(N), the temperature T of the storage battery 2 is inputable to the input layer of each of the machine learning models Ma1 to Maq. In the present modification, each of the machine learning models Ma1 to Maq is generated (constructed) using training data composed of a large number of datasets, as with the machine learning model Ma, and in each of the large number of datasets, with respect to a storage battery similar to the storage battery 2 diagnosed in the past, a parameter indicating the internal state of the battery, such as the circuit parameter ε, is associated with the electrical characteristic data Y(N) based on current time series data I(t) and the voltage time series data V(t). However, each of the machine learning models Ma1 to Maq is generated using only a dataset which falls within the applicable SOC range Δη described above.

Furthermore, in the present modification, the processing execution section 11 uses the machine learning model Mb, instead of the processing in S114, to estimate the SOC range Δη of the storage battery 2 from the target electrical characteristic data Ytar(N) of the storage battery 2 and the measurement result Ttar of the temperature T of the storage battery 2 indicated by the measurement data. Furthermore, in the present modification, measurement of the SOCη of the storage battery 2 is not performed in measurement of the measurement data. In the present modification, the processing execution section 11 inputs, to the machine learning model Mb, the target electrical characteristic data Ytar(N) based on measurement results Itar(t) and Vtar(t) regarding temporal changes in the current I and the voltage V of the storage battery 2, and the measurement results Ttar(N) regarding the temperature T of the storage battery 2. By this, the machine learning model Mb outputs, as information on the SOCη of the storage battery 2, the SOC range Δη of the storage battery 2 corresponding to the input target electrical characteristic data Ytar(N) and the measurement result Ttar. The processing execution section 11 estimates the SOC range Δη of the storage battery 2 on the basis of a result of output from the machine learning model Mb. Therefore, the present modification uses the machine learning model Mb which outputs information on the SOCη of the storage battery 2, such as the SOC range Δη, in response to input of the electrical characteristic data Y(N).

Furthermore, in the present modification, in each dataset of training data for use in generation of the machine learning model Mb, information on the SOCη of the storage battery 2, such as the SOC range Δη of the storage battery 2, is associated with the electrical characteristic data Y(N). In the present modification, the processing execution section 11 performs, instead of the processing of S115, processing of selection from the plurality of machine learning models Ma1 to Maq on the basis of the estimation result Δηest regarding the SOC range Δη estimated using the machine learning model (additional machine learning model) Mb. At this time, a machine learning model (a corresponding one of Ma1 to Maq) which is applicable to the SOC range Δη corresponding to the estimation result Δηest is selected from the machine learning models Ma1 to Maq. That is, a machine learning model (a corresponding one of Ma1 to Maq) applicable to the SOC range Δq indicated by the information regarding the SOCη of the storage battery 2 output from the machine learning model Mb is selected from the machine learning models Ma1 to Maq. Furthermore, in the present modification, the processing execution section 11 uses the selected one of the machine learning models Ma1 to Maq, instead of the processing in S112A, to estimate the internal state of the storage battery 2 from the target electrical characteristic data Ytar(N) of the storage battery 2 and the measurement result Ttar of the temperature T of the storage battery 2. At this time, as with the processing in S112 in the example shown in FIG. 4, the internal state of the storage battery 2 is estimated using the selected machine learning model (the corresponding one of Ma1 to Maq).

Furthermore, in a modification, in an aspect in which the machine learning models Ma1 to Maq and the machine learning model Mb are usable as with the first modification, etc., the plurality of machine learning models Ma1 to Maq are different from each other in terms of at least one of the applicable temperature range ΔT and SOC range Δη. That is, the machine learning models Ma1 to Maq are different from each other in terms of conditions for the applicable temperature range ΔT and SOC range Δη. Furthermore, only the electrical characteristic data Y(N) is inputable to each of the machine learning models Ma1 to Maq. In the present modification, each of the machine learning models Ma1 to Maq is generated (constructed) using training data composed of a large number of datasets, as with the machine learning model Ma, and in each of the large number of datasets, with respect to a storage battery similar to the storage battery 2 diagnosed in the past, a parameter indicating the internal state of the battery, such as the circuit parameter ε, is associated with the electrical characteristic data Y(N) based on current time series data I(t) and the voltage time series data V(t). However, each of the machine learning models Ma1 to Maq is generated using only a dataset which satisfies the conditions for the applicable temperature range ΔT and SOC range Δη described above.

Furthermore, in the present modification, the processing execution section 11 uses the machine learning model Mb, instead of the processing in S114, to estimate the temperature range ΔT and the SOC range Δη of the storage battery 2 from the target electrical characteristic data Ytar(N) of the storage battery 2. Furthermore, in the present modification, the temperature T and the SOCη of the storage battery 2 are not measured in measurement of the measurement data. In the present modification, the processing execution section 11 inputs, to the machine learning model Mb, only the target electrical characteristic data Ytar(N) based on measurement results Itar(t) and Vtar(t) regarding temporal changes in the current I and the voltage V of the storage battery 2. By this, the machine learning model Mb outputs, as information on the temperature T and the SOCη of the storage battery 2, the temperature range ΔT and the SOC range Δη of the storage battery 2 corresponding to the input target electrical characteristic data Ytar(N). The processing execution section 11 estimates the temperature range ΔT and the SOC range Δη of the storage battery 2 on the basis of a result of output from the machine learning model Mb. Therefore, the present modification uses the machine learning model Mb which outputs information on the temperature T and the SOCη of the storage battery 2 in response to input of the electrical characteristic data Y(N).

Furthermore, in the present modification, in each dataset of training data for use in generation of the machine learning model Mb, information on the temperature T and the SOCη of the storage battery 2, such as the temperature range ΔT and the SOC range Δη of the storage battery 2, is associated with the electrical characteristic data Y(N). In the present modification, the processing execution section 11 performs, instead of the processing of S115, processing of selection from the plurality of machine learning models Ma1 to Maq on the basis of the estimation results Δtest and Δηest regarding the temperature range ΔT and the SOC range Δη estimated using the machine learning model Mb. At this time, a machine learning model (a corresponding one of Ma1 to Maq) which is applicable to the conditions for the temperature range ΔT and the SOC range Δη corresponding to the estimation results ΔTest and Δηest is selected from the machine learning models Ma1 to Maq. That is, a machine learning model (a corresponding one of Ma1 to Maq) applicable to both of the temperature range ΔT and the SOC range Δη indicated by the information regarding the temperature T and the SOCη of the storage battery 2 output from the machine learning model Mb is selected from the machine learning models Ma1 to Maq. Furthermore, in the present modification, the processing execution section 11 uses the selected one of the machine learning models Ma1 to Maq, instead of the processing in S112A, to estimate the internal state of the storage battery 2 from the target electrical characteristic data Ytar(N) of the storage battery 2. At this time, as with the processing in S112 in the example shown in FIG. 4, the internal state of the storage battery 2 is estimated using the selected machine learning model (the corresponding one of Ma1 to Maq).

In an aspect in which the machine learning models Ma1 to Maq and the machine learning model Mb are usable as with the first modification, etc., each of the plurality of machine learning models Ma1 to Maq outputs the internal state of the storage battery 2 in response to input of the electrical characteristic data (e.g., Y(N)), and the machine learning models Ma1 to Maq are different from each other in terms of at least one of the applicable temperature range ΔT and SOC range Δη. The processing execution section 11 such as a processing circuit selects one of the machine learning models Ma1 to Maq to which the target electrical characteristic data (e.g., Ytar(N)) is to be input, on the basis of information on at least one of the temperature T and the SOCη of the storage battery 2. Furthermore, the machine learning model (additional machine learning model) Mb outputs information on at least one of the temperature T and the SOCη of the storage battery 2 in response to input of the electrical characteristic data (e.g., Y(N)), and the processing execution section 11 inputs the target electrical characteristic data (e.g., Ytar(N)) to the machine learning model Mb using the machine learning model Mb. The processing execution section 11 selects one of the plurality of machine learning models Ma1 to Maq to which the target electrical characteristic data is to be input, on the basis of a result of output from the machine learning model Mb in response to input of the target electrical characteristic data.

Even in an aspect in which the machine learning models Ma1 to Maq and the machine learning model Mb are usable as with the first modification, etc., the internal state of the storage battery 2 is estimated without performing the Fourier analysis on the measurement results Itar(t) and Vtar(t) regarding temporal changes in the current I and the voltage V of the storage battery 2, or the fitting calculation using the measurement result regarding the frequency characteristics of the impedance of the storage battery 2 and the equivalent circuit model. This reduces, as with the above-described embodiments, etc., the effort in analyzing the measurement data including the measurement results Itar(t) and Vtar(t) regarding the temporal changes in the current I and the voltage V of the storage battery 2. Furthermore, in an aspect in which the machine learning models Ma1 to Maq and the machine learning model Mb are usable as with the first modification, etc., at least one of the measurement of the temperature T of the storage battery 2 and the measurement of the SOCη of the storage battery 2 can be omitted in measurement of diagnostic measurement data including temporal changes in the current I and the voltage V of the storage battery 2. This reduces the effort, etc., in measuring the diagnostic measurement data in diagnosis of the storage battery 2.

In addition, in the embodiments described above, the target electrical characteristic data Ytar(N) etc., generated through processing in S111 is input to the machine learning models Ma (Ma1 to Maq), Mb etc.; however, this is not a limitation as long as electrical characteristic data based on the measurement results Itar(t) and Vtar(t) regarding temporal changes in the current I and the voltage V are input to the machine learning models Ma, Mb, etc. In a modification, a waveform itself indicating the measurement results Itar(t) and Vtar(t) regarding temporal changes in the current I and the voltage V of the storage battery 2 in a state in which a pseudo-random pulse signal of the current I is input to the storage battery 2 is input as the target electrical characteristic data of the storage battery 2 to the machine learning models Ma, Mb, etc. In such a case, the machine learning model Ma (Ma1 to Maq) outputs the internal state of the storage battery 2 in response to input of the current time series data I(t) and the voltage time series data V(t) of the storage battery 2 themselves. The machine learning model (additional machine learning model) outputs information on at least one of the temperature T and the SOCη of the storage battery 2 in response to input of the current time series data I(t) and the voltage time series data V(t) of the storage battery 2 themselves.

In the present modification also, the internal state of the storage battery 2 is estimated using at least the machine learning model Ma in a manner similar to any of the embodiments described above. Therefore, in this modification also, at least one of the measurement of the temperature T of the storage battery 2 and the measurement of the SOCη of the storage battery 2 can be omitted in measurement of diagnostic measurement data including temporal changes in the current I and the voltage V of the storage battery 2. This reduces the effort required to measure measurement data for diagnosis when diagnosing the storage battery 2.

Furthermore, in a modification, the processing execution section 11 performs data processing in S111 of the example shown in FIG. 4 in parallel with measurement of the current and voltage of the storage battery 2 in a state in which the current pseudo-random pulse signal is input. In such a case, while measuring the current and the voltage of the storage battery 2, the processing execution section 11 acquires measurement values of the current and voltage only at a prescribed time point such as a time point corresponding to the sequence parameter N. The processing execution section 11 calculates a standardization parameter Y from the measurement values of the current and the voltage only for a prescribed time point, thereby storing the calculated standardization parameter Y. Therefore, in the present modification, the acquisition of the measurement values of the current and the voltage, and the calculation of the standardization parameter Y, are performed only for a prescribed time point among all the measurement time points at which the current and voltage are measured. This achieves a reduction in data to be stored and transferred in the data processing for generating the target electrical characteristic data Ytar(N) .

According to at least one of these embodiments or examples, temporal changes in current and voltage of the storage battery are measured in a state in which a pseudo-random pulse signal of current is input to the storage battery. By using the machine learning model Ma which outputs the internal state of the storage battery in response to input of the electrical characteristic data based on the current time series data and the voltage time series data of the storage battery, the target electrical characteristic data based on the measurement result regarding temporal changes in current and voltage are input as the electrical characteristic data to the machine learning model, and the internal state of the storage battery is estimated on the basis of a result of output from the machine learning model in response to input of the target electrical characteristic data. By this, it possible to provide a diagnosis apparatus, a diagnosis system, and a diagnosis method of a storage battery, which reduce the effort in analyzing measurement data including measurement results regarding temporal changes in current and voltage of the storage battery.

Although some embodiments of the invention have been described, these embodiments are for purposes of illustration and are not intended to limit the scope of the invention. These novel embodiments may be implemented in various other forms and may be omitted, substituted, or changed in various ways without departing from the gist of the invention. These embodiments and modifications thereof are included in the scope and gist of the invention and are included in the invention disclosed in the claims and the equivalent scope thereof.

## Claims

1. A diagnosis apparatus of a storage battery, comprising a processing circuit configured to:
measure temporal changes in current and voltage of the storage battery in a state in which a pseudo-random pulse signal of current is input to the storage battery;
by using a machine learning model which outputs an internal state of the storage battery in response to input of electrical characteristic data based on current time series data and voltage time series data of the storage battery, input target electrical characteristic data based on a measurement result regarding the temporal changes in the current and the voltage as the electrical characteristic data to the machine learning model; and
estimate the internal state of the storage battery on a basis of a result of outputting from the machine learning model in response to the input of the target electrical characteristic data.

2. The diagnosis apparatus according to claim 1,
wherein
the processing circuit generates standardization time series data by standardizing the measurement result regarding the temporal change in the voltage by using an amplitude of the current in the measured temporal change in the current, and
the processing circuit generates the target electrical characteristic data to be input to the machine learning model by extracting values at a plurality of prescribed time points which are different from each other from the generated standardization time series data, and arranging the extracted values at the plurality of prescribed time points in a prescribed order.

3. The diagnosis apparatus according to claim 1,
wherein
the machine learning model outputs a circuit parameter set in an equivalent circuit model of the storage battery including a resistance component of the storage battery in response to the input of the electrical characteristic data, and
the processing circuit estimates the resistance component of the storage battery as the internal state of the storage battery on a basis of the result of the output from the machine learning model in response to the input of the target electrical characteristic data.

4. The diagnosis apparatus according to claim 3,
wherein
the processing circuit calculates a ratio of a resistance of a positive electrode to a resistance of a negative electrode in the storage battery on a basis of a result of the estimating the resistance component of the storage battery, and
the processing circuit estimates a degree of deterioration of the storage battery on a basis of the calculated ratio.

5. The diagnosis apparatus according to claim 1,
wherein
the processing circuit measures at least one of a temperature and an SOC of the storage battery in addition to the temporal changes in the current and the voltage of the storage battery, and
the processing circuit estimates the internal state of the storage battery by inputting, to the machine learning model, a result of the measuring at least one of the temperature and the SOC of the storage battery in addition to the target electrical characteristic data.

6. The diagnosis apparatus according to claim 1,
wherein
the processing circuit is capable of using a plurality of machine learning models which are different from each other in terms of at least one of an applicable temperature range and an applicable SOC range, as the machine learning model which outputs the internal state of the storage battery in response to the input of the electrical characteristic data, and
the processing circuit selects a machine learning model to which the target electrical characteristic data is to be input, from the plurality of machine learning models on a basis of information on at least one of the temperature and the SOC of the storage battery.

7. The diagnosis apparatus according to claim 6,
wherein
the processing circuit inputs, using an additional machine learning model which outputs information on at least one of the temperature and the SOC of the storage battery in response to the input of the electrical characteristic data, the target electrical characteristic data as the electrical characteristic data to the additional machine learning model, and
the processing circuit selects a machine learning model to which the target electrical characteristic data is to be input, from the plurality of machine learning models on a basis of a result of the outputting from the additional machine learning model in response to the input of the target electrical characteristic data.

8. A diagnosis system of a storage battery, comprising:
the diagnosis apparatus according to any one of claims 1 to 7; and
the storage battery in which the internal state is estimated by the diagnosis apparatus using the machine learning model.

9. A diagnosis method of a storage battery, comprising:
measuring temporal changes in current and voltage of the storage battery in a state in which a pseudo-random pulse signal of current is input to the storage battery;
by using a machine learning model which outputs an internal state of the storage battery in response to input of electrical characteristic data based on current time series data and voltage time series data of the storage battery, inputting target electrical characteristic data based on a result of the measuring the temporal changes in the current and the voltage as the electrical characteristic data to the machine learning model; and
estimating the internal state of the storage battery on a basis of a result of outputting from the machine learning model in response to input of the target electrical characteristic data.
